# EUROPÄISCHE PATENTSCHRIFT

(11) **EP 3 900 876 B1**
(45) Veröffentlichungstag und Bekanntmachung des Hinweises auf die Patenterteilung: **01.05.2024**
(21) Anmeldenummer: 20170996.1
(22) Anmeldetag: 23.04.2020
(51) Int. Cl.: B24B 37/04, B24B 37/08, B24B 37/10, B24B 55/02

(54) **VERFAHREN ZUM SCHLEIFEN EINER HALBLEITERSCHEIBE**
METHOD OF GRINDING A SEMICONDUCTOR WAFER
PROCÉDÉ DE RECTIFICATION D'UNE TRANCHE DE SEMI-CONDUCTEUR

(43) Veröffentlichungstag der Anmeldung: 27.10.2021
(73) Patentinhaber: Siltronic AG, 81677 München (DE)
(72) Erfinder: Kerstan, Michael, 84489 Burghausen (DE); Oberhans, Stephan, 83370 Seeon (DE); Weiß, Robert, 84543 Winhöring (DE)
(74) Vertreter: Killinger, Andreas

(56) Entgegenhaltungen:
- EP-A2- 0 751 553
- DE-A1-102007 030 958
- DE-B4-102007 030 958
- US-A1- 2011 183 582
- US-A1- 2019 134 782

## Beschreibung

Gegenstand der vorliegenden Erfindung ist ein Verfahren zum Schleifen einer Scheibe aus Halbleitermaterial. Die Erfindung basiert auf der optimalen Verteilung einer Flüssigkeit im Umfeld des Schleifwerkzeugs zur gleichzeitig beidseitigen Material abtragenden Bearbeitung einer Halbleiterscheibe.

Für Elektronik, Mikroelektronik und Mikro-Elektromechanik werden als Ausgangsmaterialien Halbleiterscheiben (Substrate) mit extremen Anforderungen an globale und lokale Ebenheit, einseiten-bezogene lokale Ebenheit (Nanotopologie), Rauigkeit und Sauberkeit benötigt. Halbleiterscheiben sind Scheiben aus Halbleitermaterialien, insbesondere Verbindungshalbleiter wie Galliumarsenid oder Elementhalbleiter wie Silicium und Germanium.

Gemäß dem Stand der Technik werden Halbleiterscheiben in einer Vielzahl von aufeinander folgenden Prozessschritten hergestellt. Im Allgemeinen wird folgende Herstellungssequenz benutzt:
- Herstellen eines einkristallinen Halbleiterstabs (Kristallzucht),
- Zerteilen des Halbleiterstabs in einzelne Stabstücke,
- Auftrennen des Stabs in einzelne Scheiben (Innenloch- oder Drahtsägen),
- mechanische Bearbeitung der Scheiben (Läppen, Schleifen),
- chemische Bearbeitung der Scheiben (alkalische oder saure Ätze),
- chemo-mechanische Bearbeitung der Scheiben (Politur),
- optional weitere Beschichtungsschritte (z.B. Epitaxie, Temperaturbehandlung)

Die mechanische Bearbeitung der Halbleiterscheibe dient der Entfernung von Sägewelligkeiten, dem Abtrag der durch die raueren Sägeprozesse kristallin geschädigten oder vom Sägedraht kontaminierten Oberflächenschichten und vor allem der globalen Einebnung der Halbleiterscheiben. Ferner dient die mechanische Bearbeitung der Halbleiterscheibe der Herstellung einer gleichmäßigen Dickenverteilung, d.h. dass die Scheibe eine gleichmäßige Dicke hat.

Als Verfahren zur mechanischen Bearbeitung der Halbleiterscheiben sind das Läppen sowie das Oberflächen-Schleifen (einseitig, doppelseitig) bekannt.

Die Technik des doppelseitigen Läppens von gleichzeitig mehreren Halbleiterscheiben ist seit langem bekannt und beispielsweise in der EP 547894 A1 beschrieben. Beim doppelseitigen Läppen werden die Halbleiterscheiben unter Zuführung eines Abrasivstoffes enthaltenden Suspension zwischen einer oberen und einer unteren Arbeitsscheibe, der meist aus Stahl bestehenden und mit Kanälen zur besseren Verteilung der Suspension versehenen Läppscheibe, unter einem gewissen Druck bewegt und dadurch ein Materialabtrag bewirkt. Die Halbleiterscheibe wird durch eine Läuferscheibe ("carrier") mit Aussparungen zur Aufnahme der Halbleiterscheiben während des Läppens geführt, wobei die Halbleiterscheibe durch die mittels Antriebskränze in Rotation versetzte Läuferscheibe auf einer geometrischen Bahn gehalten wird.

Beim Einseitenschleifen wird die Halbleiterscheibe rückseitig auf einer Unterlage ("chuck") gehalten und vorderseitig von einer Topfschleifscheibe unter Drehung von Unterlage und Schleifscheibe und langsamer axialer bzw. radialer Zustellung eingeebnet. Verfahren und Vorrichtungen zum einseitigen Oberflächenschleifen einer Halbleiterscheibe sind beispielsweise aus der US 2008 021 40 94 A1 oder aus EP 0 955 126 A2 bekannt.

Beim simultanen Doppelseitenschleifen ("(simultaneous)-double-disc grinding", sDDG) wird die Halbleiterscheibe frei schwimmend zwischen zwei, auf gegenüberliegenden kollinearen Spindeln montierten Schleifscheiben gleichzeitig beidseitig bearbeitet und dabei weitgehend frei von Zwangskräften axial zwischen einem vorder- und rückseitig wirkenden Wasser- (hydrostatisches Prinzip) oder Luftkissen (aerostatisches Prinzip) geführt und radial lose von einem umgebenden dünnen Führungsring oder von einzelnen radialen Speichen am Davonschwimmen gehindert. Verfahren und Vorrichtungen zum simultanen doppelseitigen Oberflächenschleifen einer Halbleiterscheibe sind beispielsweise aus EP 0 755 751 A1, EP 0 971 398 A1, DE 10 2004 011 996 A1 sowie DE 10 2006 032 455 A1 bekannt.

Allerdings verursacht das doppelseitige Schleifen von Halbleiterscheiben (DDG) kinematisch bedingt grundsätzlich einen höheren Materialabtrag im Zentrum der Halbleiterscheibe ("Schleifnabel"). Um nach dem Schleifen eine Halbleiterscheibe mit möglichst guter Geometrie zu erhalten, ist es notwendig, dass die beiden Schleifspindeln, auf denen die Schleifscheiben montiert werden, exakt kollinear ausgerichtet sind, da radial und oder axiale Abweichungen einen negativen Einfluss auf die Form und Nanotopologie der geschliffenen Scheibe haben. Die deutsche Anmeldung DE 10 2007 049 810 A1 lehrt beispielsweise ein Verfahren zur Korrektur der Schleifspindelposition in Doppelseitenschleifmaschinen.

Bei den Schleifprozessen - dies betrifft sowohl einseitige als auch beidseitige Schleifverfahren, ist eine Kühlung des Schleifwerkzeuges und/oder der bearbeiteten Halbleiterscheibe erforderlich. Als Kühlmittel wird üblicherweise Wasser bzw. deionisiertes Wasser verwendet. Bei den Doppelseitenschleifmaschinen tritt das Kühlmittel üblicherweise aus dem Zentrum des Schleifwerkzeugs aus und wird mittels Zentrifugalkraft zu den Schleifzähnen, die kreisförmig am Außenrand der Schleifscheibe angeordnet sind, transportiert bzw. geschleudert. Der Kühlmitteldurchsatz, also die Menge an Kühlmittel, die innerhalb einer definierten Zeit austritt, kann elektronisch oder mechanisch geregelt werden.

Die Schrift DE 10 2007 030 958 A1 lehrt ein Verfahren zum Schleifen von Halbleiterscheiben, bei dem die Halbleiterscheiben einseitig oder beidseitig mittels wenigstens eines Schleifwerkzeugs, unter Zuführung eines Kühlmittels Material abtragend bearbeitet werden. Um eine konstante Kühlung während des Schleifens zu gewährleisten, wird der Kühlmittelfluss mit abnehmender Schleifzahnhöhe reduziert, da ein unverändert hoher Kühlmittelfluss andernfalls unvermeidlich zu Aquaplaning-Effekten führen würde.

Die Erfindung in der Schrift DE 10 2017 215 705 A1 basiert auf der optimalen Verteilung einer Flüssigkeit in einem Schleifwerkzeug zur gleichzeitig beidseitigen Material abtragenden Bearbeitung einer Halbleiterscheibe, die durch eine optimierte Schleuderplatte erzielt wird. Dabei wird gelehrt, dass sich eine ungleiche Verteilung der Flüssigkeit ungünstig auf das Schleifergebnis auswirkt.

Die Patentschrift US 2019/134782 A1 zeigt bestimmte Ausprägungen von Schleifscheiben, die für das Doppelseitenschleifen verwendung finden können. Ferner wird die Verwendung von Wasser gelehrt, das mittels einer Düse auf die Halbleiterscheibe gebracht wird.

Die Patentschrift DE 10 2007 030958 A1 lehrt ein Verfahren zum Schleifen von Halbleiterscheiben, bei dem die Schleifwassermenge in Abhängigkeit der Zahnhöhe dem Prozess zugeführt wird.

### Problembeschreibung

Alle genannten Schriften des Standes der Technik ist der Nachteil gemein, dass der Materialabtrag im Zentrum der Halbleiterscheiben höher ist als am Rand. Dadurch verschlechtern sich die Geometrieparameter der Halbleiterscheibe in diesem Bearbeitungsschritt. Diese Abweichung kann in den darauffolgenden Bearbeitungsschritten nicht oder nur ungenügend korrigiert werden.

### Beschreibung der Aufgabe

Aufgabe der vorliegenden Erfindung ist es, ein Verfahren bereitzustellen, das die eben genannten Nachteile nicht zeigt.

### Beschreibung der Lösung der Aufgabe

Die Aufgabe wird gelöst durch ein Verfahren zum Schleifen einer Halbleiterscheibe, wobei die Halbleiterscheibe mittels eines Schleifwerkzeugs enthaltend Schleifzähne mit einer Höhe **h** unter Zuführung eines Kühlmediums in einen Kontaktbereich zwischen Halbleiterscheibe und dem Schleifwerkzeug Material abtragend bearbeitet werden, dadurch gekennzeichnet, dass zu jedem Zeitpunkt des Schleifens eine Spülflüssigkeit auf einen Bereich auf einer Seite der Halbleiterscheibe mittels einer Düse aufgebracht wird.

Es hat sich besonders vorteilhaft erwiesen, wenn gekennzeichnet beide Seiten der Halbleiterscheibe materialabtragend bearbeitet werden und eine Spülflüssigkeit auf einen Bereich auf beiden Seiten der Halbleiterscheibe aufgebracht wird.

Besonders bevorzugt ist dabei, wenn die Menge des Kühlmittels pro Zeit mit abnehmender Höhe **h** der Schleifzähne des Schleifwerkzeugs reduziert wird. Vorteilhaft ist es, wenn die Summe aus der Menge des Kühlmittels pro Zeit und der Menge der Spülflüssigkeit pro Zeit während des Schleifens konstant bleibt.

Der Überdruck der Spülflüssigkeit gemessen an der verwendeten Düse beträgt bevorzugt nicht weniger als 0,1 bar und besonders bevorzugt nicht mehr als 0,5 bar. Bevorzugt ist darauf zu achten, dass die Menge der Spülflüssigkeit pro Zeit nicht weniger als 0,1 l/min und nicht mehr als 1 l/min beträgt.

Besonderes Augenmerk gilt darauf zu richten, auf welchen Bereich auf der Halbleiterscheibe der Fluss der Spülflüssigkeit während des Schleifens gerichtet ist. Das Auftragen erfolgt in einem Bereich mit einem Abstand nicht kleiner als 2 mm, bevorzugt 4 mm und nicht größer als 10 mm, bevorzugt nicht größer als 6 mm zum Zentrum der Halbleiterscheibe.

Die verwendete Düse hat dabei bevorzugt eine Fläche nicht größer ist als 1,5 mm². und nicht kleiner als 0,1 mm².

Besonders bevorzugt ist, dass die Menge der Spülflüssigkeit pro Zeit während des gesamten Prozesses des Schleifens konstant bleibt.

### Kurzbeschreibung der Figuren

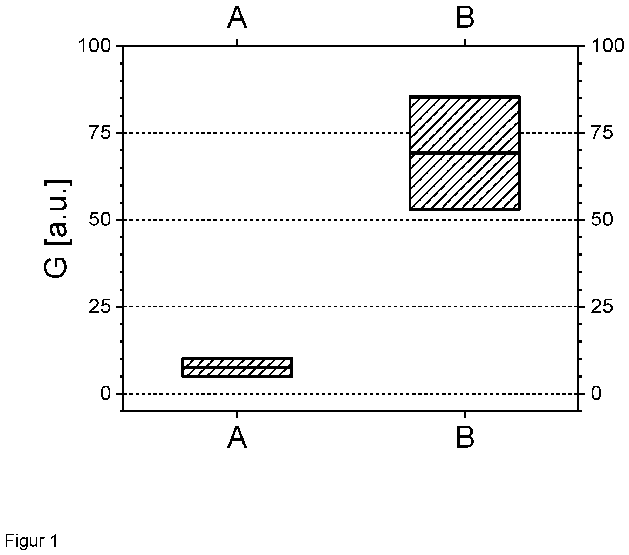

**Figur 1** zeigt das Ergebnis zweier Versuchsreihen bezüglich Geometrie im Zentrum von Halbleiterscheiben. Die Ordinate zeigt dabei die Abweichung der Geometrie (G) von einer Idealgeometrie im Zentrumsbereich der Halbleiterscheiben.

Die Halbleiterscheiben der Gruppe B (Stand der Technik) zeigen hierbei im Mittel eine größere Abweichung von der gewünschten Geometrie als die Halbleiterscheiben der Gruppe A (erfindungsgemäß). Es fällt außerdem auf, dass die statistische Verteilung der gemessenen Abweichungen für das erfindungsgemäße Verfahren (Gruppe A) eine schmalere Verteilung verursacht als bei den als bei den Halbleiterscheiben, die nach dem Stand der Technik prozessiert wurden (Gruppe B).

### Detaillierte Beschreibung erfindungsgemäßer Ausführungsbeispiele

Ein Kristallstück mit einem Nenndurchmesser von 300 mm aus Silicium gewonnen aus einem Kristallstab, der mit der Czochralski Methode gezogen wurde, wurde mittels einer Drahtsäge in Halbleiterscheiben geschnitten. Die so erhaltenen Halbleiterscheiben wurden in zwei Gruppen **"A"** und **"B"** unterteilt, wobei jede zweite Halbleiterscheibe in Gruppe A zugeordnet und die restlichen Halbleiterscheiben in Gruppe "B" zugeordnet wurden.

Auf einer Schleifanlage vom Typ Koyo DSGX320 wurden die Halbleiterscheiben beider Gruppen **A** und **B** geschliffen. Die Schleifanlage war dabei bestückt mit einem kommerziell erhältlichen Schleifwerkzeug ("Grind Wheel") der Firma ALMT, Typ #3000-OVH.

Die Halbleiterscheiben der Gruppe **B** wurden dabei nach Stand der Technik geschliffen.

Gemäß dem Stand der Technik wird die Schleifwassermenge zahnhöhenabhängig (gemäß DE 10 2007 030 958 A1) geregelt dem Prozess zugeführt. Hierdurch wird sichergestellt, dass es weder zu einem Aquaplaning gleichen Aufschwimmen des Werkzeugs auf dem zu bearbeitenden Wafer kommt, wenn im Prozess zu viel Schleifwasser auf dem Weg vom Werkzeuginneren nach außen gepresst wird, bzw. es zu einer Schleifbrand gleichen Überhitzung des zu bearbeitenden Wafers sowie zu Versagen der Schleifscheibe kommt, wenn zu wenig Schleifwasser im Prozess zur Verfügung steht.

Die Halbleiterscheiben der Gruppe **A** wurden hingegen mit einem Verfahren geschliffen, bei dem während des Schleifvorganges zusätzlich zum Kühlmedium, das während des Schleifens verwendet wird, um den Halbleiterwafer zu kühlen, eine Spülflüssigkeit hinzugefügt wird. Dabei wurde darauf geachtet, dass die Spülflüssigkeit zu jedem Zeitpunkt einen nennenswerten Fluss aufweist.

Als nennenswerter Fluss ist dabei ein Fluss von 0,01 l/min zu verstehen.

Für die Spülflüssigkeit wurde bevorzugt Wasser verwendet, es ist aber auch denkbar, dass zusätzlich Additive verwendet werden.

Durch diese Zugabe eines Spülmediums hat sich gezeigt, dass die Geometrie im Zentrum des Wafers sich erheblich verbessert. Wird jedoch der Fluss des Spülmediums während des Schleifvorganges unterbrochen, verschlechtert sich auch die Geometrie der Halbleiterscheibe im Zentrum wieder.

Erfindungsgemäß ist es, wenn das Spülmedium im Wesentlichen auf einen Bereich um das Zentrum der Halbleiterscheibe gerichtet ist. Erfindungsgemäß ist es, wenn während des Schleifens der Bereich einen Abstand nicht kleiner als 2 mm, bevorzugt 4 mm und nicht größer als 10 mm, bevorzugt nicht größer als 6 mm zum Zentrum der Halbleiterscheibe hat.

Ganz besonders gut scheint der Effekt zu sein, wenn der Fluss des Spülmediums mehr als 0,1 l/min und nicht mehr als 1 l/m in beträgt.

Die Erfinder haben erkannt, dass die Verwendung einer Düse mit einem minimalen Düsenquerschnitt zwischen 0,1 mm² und 1,5 mm² sich besonders vorteilhaft auf den Effekt auswirkt.

Die Erfinder haben ferner erkannt, dass offenbar auch der eingestellte Druck eine Rolle bei der Verbesserung spielt. So wirkt sich ein eingestellter Überdrück an der Düse zwischen 0,1 bar und 0,5 bar besonders positiv aus.

Die beiden Gruppen von Halbleiterscheiben "A" und "B" wurden nach dem Schleifen bezüglich der erreichten Geometrie vermessen. Dabei wurde die jeweilige Abweichung der gemessenen Geometrie im Zentrum der Halbleiterscheibe mit einer idealen Geometrie verglichen und der Unterschied als eine Maßzahl angegeben.

Figur 1 zeigt den Vergleich der Halbleiterscheiben der Gruppe A (erfindungsgemäß) und der Halbleiterscheiben der Gruppe B (Stand der Technik).

Die Halbleiterscheiben der Gruppe B (Stand der Technik) weisen hierbei im Mittel eine größere Abweichung von der gewünschten Geometrie als die Halbleiterscheiben der Gruppe A (erfindungsgemäß) auf. Das erfindungsgemäße Verfahren verbessert also die Geometrie im Zentrum der Halbleiterscheiben im Vergleich zum Verfahren nach dem Stand der Technik.

Zudem fällt auf, dass die statistische Verteilung der gemessenen Abweichungen für das erfindungsgemäßen Verfahren (Gruppe A) eine schmalere Verteilung verursacht als bei den Halbleiterscheiben, die nach dem Stand der Technik prozessiert wurden (Gruppe B). Das heißt, dass das erfindungsgemäße Verfahren auch noch zusätzliche Vorteile bezüglich der statistischen Verteilung der Geometriewerte im Zentrum der Halbleiterscheiben bietet.

Die Erfinder waren überrascht davon, dass eine verhältnismäßig kleine Menge an Spülflüssigkeit, die nicht in den direkten Wirkbereich der Schleifscheiben aufgebracht wird, eine große Wirkung in der Verbesserung der Geometrie erzielt.

Über die entsprechenden Zusammenhänge und Ursachen lässt sich bis jetzt spekulieren, offenkundig sind sie den Erfindern nicht.

## Patentansprüche

1. Verfahren zum Schleifen einer Halbleiterscheibe,
wobei die Halbleiterscheibe mittels eines Schleifwerkzeugs enthaltend Schleifzähne mit einer Höhe **h** unter Zuführung eines Kühlmediums in einen Kontaktbereich zwischen Halbleiterscheibe und dem Schleifwerkzeug Material abtragend bearbeitet werden, wobei zu jedem Zeitpunkt des Schleifens eine Spülflüssigkeit auf einen Bereich auf einer Seite der Halbleiterscheibe mittels einer Düse aufgebracht wird,
**dadurch gekennzeichnet, dass**
der Bereich einen Abstand nicht kleiner als 2 mm und nicht größer als 10 mm zum Zentrum der Halbleiterscheibe hat.

2. Verfahren nach Anspruch 1, **dadurch gekennzeichnet, dass** gleichzeitig beide Seiten der Halbleiterscheibe materialabtragend bearbeitet werden und eine Spülflüssigkeit auf einen Bereich auf beiden Seiten der Halbleiterscheibe aufgebracht wird.

3. Verfahren nach einem der vorhergehenden Ansprüche,
**dadurch gekennzeichnet, dass**
die Menge des Kühlmittels pro Zeit mit abnehmender Höhe h reduziert wird.

4. Verfahren nach einem der vorhergehenden Ansprüche,
**dadurch gekennzeichnet, dass**
die Summe aus der Menge des Kühlmittels pro Zeit und der Menge der Spülflüssigkeit pro Zeit konstant bleibt.

5. Verfahren nach einem der vorhergehenden Ansprüche,
**dadurch gekennzeichnet, dass**
der Überdruck der Spülflüssigkeit gemessen an der Düse nicht weniger als 0,1 bar beträgt.

6. Verfahren nach einem der vorhergehenden Ansprüche,
**dadurch gekennzeichnet, dass**
der Überdruck der Spülflüssigkeit gemessen an der Düse nicht mehr als 1,0 bar beträgt.

7. Verfahren nach einem der vorhergehenden Ansprüche,
**dadurch gekennzeichnet, dass**
die Menge der Spülflüssigkeit pro Zeit nicht weniger als 0,01 l/min und nicht mehr als 1 l/min beträgt.

8. Verfahren nach einem der vorhergehenden Ansprüche, **dadurch gekennzeichnet, dass**
der Bereich einen Abstand nicht kleiner als 4 mm und nicht größer als 6 mm zum Zentrum der Halbleiterscheibe hat.

9. Verfahren nach einem der vorhergehenden Ansprüche, **dadurch gekennzeichnet, dass**
die Fläche einer Düse nicht größer ist als 1,5 mm² und nicht kleiner als 0,1 mm².

10. Verfahren nach einem der vorhergehenden Ansprüche, **dadurch gekennzeichnet, dass**
die Menge der Spülflüssigkeit pro Zeit während des Schleifens konstant bleibt.

## Claims

1. Method for grinding a semiconductor wafer,
wherein the semiconductor wafers are machined by means of a grinding tool containing grinding teeth with a height **h** while feeding a cooling medium into a contact region between the semiconductor wafer and the grinding tool, wherein at all times during the grinding operation a rinsing liquid is applied to a region on one side of the semiconductor wafer by means of a nozzle,
**characterized in that**
the region is at a spacing not less than 2 mm and not greater than 10 mm from the centre of the semiconductor wafer.

2. Method according to Claim 1,
**characterized in that**
both sides of the semiconductor wafer are machined, and a rinsing liquid is applied to a region on both sides of the semiconductor wafer, at the same time.

3. Method according to either of the preceding claims,
**characterized in that**
the amount of coolant per unit time is reduced as the height **h** decreases.

4. Method according to one of the preceding claims,
**characterized in that**
the sum of the amount of coolant per unit time and the amount of rinsing liquid per unit time remains constant.

5. Method according to one of the preceding claims,
**characterized in that**
the excess pressure of the rinsing liquid, measured at the nozzle, is not less than 0.1 bar.

6. Method according to one of the preceding claims,
**characterized in that**
the excess pressure of the rinsing liquid, measured at the nozzle, is not more than 1.0 bar.

7. Method according to one of the preceding claims,
**characterized in that**
the amount of rinsing liquid per unit time is not less than 0.01 l/min and not more than 1 l/min.

8. Method according to one of the preceding claims,
**characterized in that**
the region is at a spacing not less than 4 mm and not greater than 6 mm from the centre of the semiconductor wafer.

9. Method according to one of the preceding claims,
**characterized in that**
the surface area of a nozzle is not greater than 1.5 mm² and not less than 0.1 mm².

10. Method according to one of the preceding claims,
**characterized in that**
the amount of rinsing liquid per unit time during the grinding operation remains constant.

## Revendications

1. Procédé de meulage d'une tranche semi-conductrice, dans lequel la tranche semi-conductrice est traitée de façon à enlever de la matière au moyen d'un outil de meulage comprenant des dents de meulage d'une hauteur h tout en fournissant un agent de refroidissement entre la tranche semi-conductrice et l'outil de meulage, un liquide de rinçage étant appliqué à chaque moment du meulage, sur une zone d'un côté de la tranche semi-conductrice au moyen d'une buse,
**caractérisé en ce que**
la zone est à une distance non inférieure à 2 mm et non supérieure à 10 mm du centre de la tranche semi-conductrice.

2. Procédé selon la revendication 1, **caractérisé en ce que** les deux côtés de la tranche semi-conductrice sont traités simultanément par enlèvement de matière et **en ce qu'**un liquide de rinçage est appliqué sur une zone des deux côtés de la tranche semi-conductrice.

3. Procédé selon l'une des revendications précédentes,
**caractérisé en ce que**
la quantité de liquide de refroidissement par unité de temps est réduite lorsque la hauteur **h** diminue.

4. Procédé selon l'une des revendications précédentes,
**caractérisé en ce que**
la somme de la quantité d'agent de refroidissement par unité de temps et de la quantité de liquide de rinçage par unité de temps reste constante.

5. Procédé selon l'une des revendications précédentes,
**caractérisé en ce que**
la surpression du liquide de rinçage mesurée au niveau de la buse n'est pas inférieure à 0,1 bar.

6. Procédé selon l'une des revendications précédentes,
**caractérisé en ce que**
la surpression du liquide de rinçage mesurée au niveau de la buse n'est pas supérieure à 1,0 bar.

7. Procédé selon l'une des revendications précédentes,
**caractérisé en ce que**
la quantité de liquide de rinçage par unité de temps n'est pas inférieure à 0,01 l/min et n'est pas supérieure à 1 l/min.

8. Procédé selon l'une des revendications précédentes,
**caractérisé en ce que**
la zone est située à une distance non inférieure à 4 mm et non supérieure à 6 mm du centre de la tranche semi-conductrice.

9. Procédé selon l'une des revendications précédentes,
**caractérisé en ce que**
la surface d'une buse n'est pas supérieure à 1,5 mm² et pas inférieure à 0,1 mm².

10. Procédé selon l'une des revendications précédentes,
**caractérisé en ce que**
la quantité de liquide de rinçage par unité de temps reste constante pendant le meulage.
